(19) **Europäisches Patentamt**
**European Patent Office**
**Office européen des brevets**

(11) **EP 1 566 081 B1**

(12) **FASCICULE DE BREVET EUROPEEN**

(45) Date de publication et mention
de la délivrance du brevet:
**22.08.2007 Bulletin 2007/34**

(51) Int Cl.:
*H05H 1/46* (2006.01)          *C23C 16/04* (2006.01)
*H01J 37/32* (2006.01)          *B65D 23/02* (2006.01)
*C23C 16/511* (2006.01)

(21) Numéro de dépôt: **03789500.0**

(22) Date de dépôt: **25.11.2003**

(86) Numéro de dépôt international:
**PCT/FR2003/003485**

(87) Numéro de publication internationale:
**WO 2004/052060 (17.06.2004 Gazette 2004/25)**

(54) **PROCEDE ET DISPOSITIF POUR DEPOSER PAR PLASMA MICRO-ONDES UN REVETEMENT SUR UNE FACE D'UN RECIPIENT EN MATERIAU THERMOPLASTIQUE**

VERFAHREN UND VORRICHTUNG ZUM BESCHICHTEN MITTELS MIKROWELLEN-PLASMAS AUF EINER FLÄCHE EINES BEHÄLTERS AUS THERMOPLASTISCHEM MATERIAL

METHOD AND DEVICE FOR MICROWAVE PLASMA DEPOSITION OF A COATING ON A THERMOPLASTIC CONTAINER SURFACE

(84) Etats contractants désignés:
**AT BE BG CH CY CZ DE DK EE ES FI FR GB GR HU IE IT LI LU MC NL PT RO SE SI SK TR**

(30) Priorité: **28.11.2002 FR 0214961**

(43) Date de publication de la demande:
**24.08.2005 Bulletin 2005/34**

(73) Titulaire: **SIDEL PARTICIPATIONS**
**76930 Octeville-sur-Mer (FR)**

(72) Inventeurs:
• **Rius, Jean-Michel**
  **F-76930 Octeville sur Mer (FR)**

• **Pernel, Yann**
  **F-76930 Octeville sur Mer (FR)**

(74) Mandataire: **Louiset, Raphael**
**Cabinet Plasseraud**
**52 rue de la Victoire**
**75440 Paris Cedex 09 (FR)**

(56) Documents cités:
| | |
|---|---|
| EP-A- 0 778 089 | FR-A- 2 776 540 |
| US-A- 4 866 346 | US-A- 5 311 103 |
| US-A- 5 834 744 | US-A- 6 057 645 |
| US-A- 6 117 496 | US-B1- 6 328 805 |

**Description**

La présente invention concerne des perfectionnements apportés dans le domaine du dépôt d'un revêtement sur une face d'un récipient en matériau thermoplastique à l'aide d'un plasma à basse pression par excitation d'un gaz précurseur par des ondes électromagnétiques UHF dans une cavité sous vide (ou réacteur) de forme circulaire recevant ledit récipient.

Il s'agit plus particulièrement de déposer une couche barrière à l'intérieur de bouteilles ou de pots en matière thermoplastique telle que le PET afin d'améliorer les propriétés barrière aux gaz intérieurs ou aux gaz extérieurs, et éventuellement pour améliorer l'isolation du produit de remplissage desdites bouteilles ou pots vis-à-vis de l'extérieur.

Un dispositif permettant de déposer un tel revêtement à l'aide d'un plasma à basse pression par excitation d'un gaz précurseur à l'aide d'ondes électromagnétiques UHF est décrit et représenté dans le document FR 2 799 994. Le générateur UHF est raccordé à la cavité par un guide d'ondes UHF qui débouche dans une fenêtre de la paroi latérale de la cavité, avec un mode de couplage TM 020 qui engendre dans la cavité un champ central axial. Pour subir le traitement envisagé, le récipient à traiter est donc disposé au centre de la cavité, dans une enveloppe en quartz coaxiale à la cavité.

Dans une machine de mise en oeuvre industrielle, plusieurs dispositifs (typiquement au nombre de 20) sont réunis sur une structure tournante qui est capable de traiter environ 10 000 bouteilles/heure.

Ces machines donnent satisfaction quant à la qualité des récipients obtenus.

Toutefois les utilisateurs souhaitent vivement une cadence de traitement plus élevée.

Une augmentation de cadence pourrait certes être obtenue en installant un nombre plus élevé de dispositifs sur la structure tournante. Toutefois, cette augmentation du nombre des dispositifs ne pourrait être rendue possible que par un accroissement des dimensions de la structure tournante. Il en résulterait une machine plus encombrante, plus lourde et donc plus coûteuse, ce qui n'est pas acceptable.

De même, la mise en oeuvre d'une seconde machine fonctionnant en parallèle avec la première permettrait certes de doubler la cadence, mais là encore il en résulterait un encombrement plus important et un coût plus élevé qui ne sont pas acceptables.

L'invention a par conséquent pour objet de proposer un perfectionnement des dispositifs existants conduisant à une machine plus performante en terme de production tout en conservant un encombrement et un coût acceptables.

A ces fins, selon un premier de ses aspects, l'invention propose un procédé de dépôt d'un revêtement sur une face d'au moins un récipient en matériau thermoplastique à l'aide d'un plasma à basse pression par excitation d'un gaz précurseur par des ondes électromagnétiques UHF dans une cavité sous vide de forme circulaire recevant ledit récipient, lequel procédé se caractérise, selon l'invention, en ce qu'on choisit une fréquence des ondes électromagnétiques UHF qui est telle et on donne à la cavité (1) une dimension qui est telle que soit créé un mode de couplage propre à engendrer plusieurs champs électromagnétiques à l'intérieur de la cavité et en ce qu'on dispose plusieurs récipients dans ladite cavité (1) respectivement coaxialement aux champs électromagnétiques, ce grâce à quoi il est possible de traiter simultanément plusieurs récipients dans la même cavité. Dans un mode de mise en oeuvre préféré, on établit un mode de couplage TM 120 qui génère à l'intérieur de la cavité deux champs symétriques ayant eux-mêmes deux zones d'énergie distinctes, ce grâce à quoi on peut traiter simultanément deux récipients dans ladite cavité, ce procédé offrant l'avantage de pouvoir être mis en oeuvre de façon simple en conjonction avec les magnétrons à fréquence de 2,455 GHz couramment disponibles dans le commerce.

Ainsi, grâce au procédé de l'invention, on est en mesure de doubler la cadence de traitement de récipients uniquement grâce à un aménagement des moyens actuellement connus et donc dans des conditions relativement économiques.

Selon un second de ses aspects, l'invention propose, pour la mise en oeuvre du procédé précité, un dispositif de dépôt d'un revêtement sur une face d'un récipient en matériau thermoplastique à l'aide d'un plasma à basse pression par excitation d'un gaz précurseur par des ondes électromagnétiques UHF dans une cavité sous vide de forme circulaire recevant ledit récipient, comprenant un générateur d'ondes UHF et un guide d'ondes UHF pour raccorder ledit générateur à une fenêtre de la paroi latérale de la cavité, lequel dispositif, étant agencé conformément à l'invention, se caractérise en ce que le générateur émet une onde électromagnétique ayant une fréquence f = 2,455 GHz et le diamètre de la cavité est sensiblement de 273 mm pour l'établissement d'un mode de couplage TM 120 générant dans la cavité deux champs symétriques ayant eux-mêmes deux zones d'énergie distinctes, ce grâce à quoi il est possible de traiter simultanément deux récipients dans ladite cavité.

Le générateur est un magnétron d'utilisation courante dans d'autres domaines. Quant au diamètre de la cavité, il est parfaitement compatible avec les structures des machines actuelles. Il s'avère donc possible, à travers un simple aménagement des machines actuelles, de doubler la capacité de traitement des machines puisque le diamètre de la cavité autorise le traitement simultané de deux bouteilles du type demi-litre ou moins disposées côte à côte respectivement dans les deux champs centraux.

Avantageusement notamment, la cavité renferme deux enveloppes en quartz disposées respectivement sensiblement coaxialement aux deux champs symétriques susmentionnés, la cavité comporte une fenêtre unique pour l'injection des ondes UHF, la fenêtre étant située symétriquement à cheval sur le plan de symétrie de part et d'autre duquel sont situés les deux champs centraux, et un couvercle unique d'obturation de la cavité est équipé d'un unique raccordement à une source de vide qui est dédoublé pour être relié aux deux susdites enveloppes respectivement, de deux injecteurs de gaz précurseur raccordés à une source unique de gaz précurseur et de deux moyens de support pour respectivement les deux récipients, de sorte que la mise en oeuvre des dispositions de l'invention n'entraîne pas un doublement du matériel nécessaire (tels que capteurs de pression intérieur et extérieur au récipient).

Il est avantageux que le dispositif comprenne également des plateaux inférieur et supérieur dont la position de chacun est réglable et qui sont propres à agir sur les champs de retour respectifs afin d'affiner le couplage en fonction de divers types de récipients susceptibles d'être traités.

Dans le cadre de l'application préférée spécifiquement envisagée, le dispositif est agencé pour le revêtement interne de récipients et à cette fin les injecteurs de gaz précurseur sont agencés pour plonger à l'intérieur des récipients respectifs lorsque ceux-ci sont supportés par des moyens de support dans les enveloppes.

L'invention sera mieux comprise à la lecture de la description détaillée qui suit d'un mode préféré de réalisation tout particulièrement adapté au revêtement interne de récipients et donné uniquement à titre d'exemple non limitatif. Dans cette description, on se réfère aux dessins annexés sur lesquels :

- la figure 1 est un schéma illustrant les conditions de mise en oeuvre du procédé de l'invention ; et
- la figure 2 est une représentation schématique d'un dispositif mettant en oeuvre le procédé de l'invention.

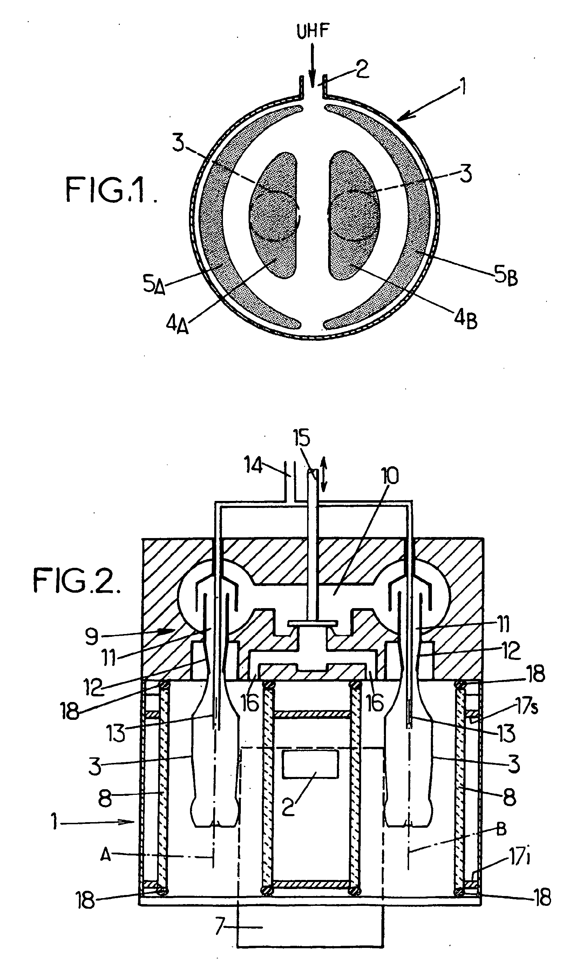

A la figure 1 est schématisée une cavité 1 de forme générale cylindrique de révolution qui présente, dans sa paroi latérale, une ouverture 2 par laquelle débouche un guide d'ondes raccordé à un générateur d'ondes électromagnétiques UHF (non représenté).

Le générateur UHF est un magnétron fonctionnant sur une fréquence de 2,455 GHz.

Pour pouvoir traiter plusieurs récipients 3 simultanément dans la cavité 1 (les deux récipients 3 sont schématisés en tirets), on choisit de dimensionner la cavité, en relation avec la fréquence des ondes électromagnétiques UHF, de manière à obtenir un mode de couplage générant plusieurs champs électromagnétiques à l'intérieur de la cavité, chaque récipient 3 étant disposé coaxialement dans un champ respectif.

Pour une mise en oeuvre pratique de cette disposition, on établit un mode de couplage TM 120 qui génère deux champs électromagnétiques symétriques ayant eux-mêmes deux zones d'énergie distinctes, à savoir deux champs centraux $4_A$ et $4_B$, ainsi que deux champs de retour $5_A$, $5_B$ situés périphériquement, en forme de haricots, en regard des champs intérieurs, comme illustré à la figure 1. Les deux récipients 3 à traiter sont disposés coaxialement dans les champs centraux $4_A$, $4_B$ respectivement. De plus, il est souhaitable que des plateaux inférieur $17_i$ et supérieur $17_s$ (visibles sur la figure 2), à positions réglables, agissent sur le champ de retour $5_A$, $5_B$ pour affiner le couplage du réacteur en fonction des divers types de récipients 3 susceptibles d'être traités.

Dans ces conditions, la longueur d'onde de coupure est

$$\lambda_c = \frac{2\pi \cdot R}{U_{12}}$$

où R est le rayon de la cavité et $U_{12}$ caractérisant le mode $T_{120}$ a pour valeur $U_{12} = 7,0156$.

La longueur d'onde de coupure $\lambda_c$ a une valeur proche (légèrement supérieure) de la longueur d'onde $\lambda$ du générateur.

$$\lambda = \frac{v}{f} = \frac{3 \times 10^8}{2,455 \times 10^9} = 12,22 \, cm \rightarrow \lambda_c \, \# \, 12,225 \, cm$$

Le rayon R de la cavité est :

$$R = \frac{\lambda_c \times U_{12}}{2\pi} = \frac{12,225 \times 7,0156}{2\pi} = 13,65 \, cm$$

La cavité doit donc présenter un diamètre de sensiblement 273 mm.

Le diamètre de la cavité 1 ainsi constituée permet de traiter simultanément deux récipients tels que deux bouteilles de 50 cl ou moins. Grâce à ce mode de fonctionnement, on double la capacité de traitement de chaque cavité, ce qui permet de répondre très favorablement aux souhaits des utilisateurs tout en conservant une cavité ayant des dimensions compatibles avec les structures tournantes actuellement réalisées. Autrement dit, les dispositions conformes à l'invention peuvent être mises en oeuvre sans qu'il soit nécessaire de repenser la totalité de la structure tournante.

A la figure 2 est illustré en vue de côté un dispositif de traitement de récipients élaboré autour de la cavité 1 présentée schématiquement à la figure 1.

Le dispositif représenté à la figure 2, désigné dans son ensemble par la référence numérique 6, comporte une cavité (ou réacteur) 1 cylindrique de révolution ayant un diamètre de sensiblement 273 mm. La paroi latérale de la cavité 1 comporte, approximativement à mi-hauteur, une ouverture 2 par laquelle débouche un guide d'ondes (non visible) raccordé à un générateur UHF 7 (en grande partie caché par la cavité) - par exemple constitué par un magnétron - propre à fonctionner sur la fréquence de 2,455 GHz. Ce dispositif génère un mode de couplage TM 120, avec deux champs centraux comme illustré à la figure 1, ces deux champs centraux étant centrés sur les axes A et B montrés à la figure 2.

L'agencement du dispositif est transposé de celui d'un dispositif de traitement d'un récipient unique tel que décrit et représenté notamment dans le document FR-A-2 799 994 déjà cité. En particulier, on dispose dans la cavité deux enveloppes 8 en quartz disposées coaxialement aux axes A et B et à l'intérieur desquelles sont disposés les deux récipients 3 respectivement ; ces deux enveloppes 8 sont montées de façon étanche (joints 18) dans la cavité et déterminent chacune une enceinte de volume réduit dans laquelle le récipient peut être disposé et qui facilite l'obtention du vide exigé par la génération du plasma nécessaire au dépôt du revêtement dans chaque récipient.

Toutefois, un avantage de l'agencement retenu réside dans le fait que la superstructure du dispositif demeure unique. Autrement dit, le couvercle unique 9 de la cavité incorpore, d'une part, les organes 10 de support des deux récipients 3 et, d'autre part, les moyens de raccordement nécessaires à la mise sous vide de la cavité et à l'insufflation du gaz précurseur nécessaire à la formation du plasma, ainsi que le capteur de pression intérieur et le capteur de pression extérieur.

Ainsi, le couvercle 9 est pourvu d'une chambre 10 raccordée (par un conduit non visible sur la figure 2) à une source de vide, laquelle chambre 10 s'étend au-dessus des deux récipients 3 et est en communication en 11 avec l'intérieur des récipients. Dans l'exemple représenté, le passage 11 est combiné avec les moyens de support 12 de chaque récipient 3.

Conformément à la mise en oeuvre préférée de l'invention pour le revêtement interne de récipients, chaque passage 11 est traversé coaxialement par un injecteur 13 de gaz précurseur qui plonge à l'intérieur du récipient 3 correspondant. Les deux injecteurs 13 peuvent être raccordés, à l'extérieur du couvercle 9, à un conduit 14 unique de liaison avec une source (non visible sur les figures) de gaz précurseur.

On peut en outre équiper le couvercle 9 avec une soupape 15, pour faire communiquer la chambre 10 avec des conduits 16 soit pour mettre en communication l'intérieur des récipients 3 et l'intérieur des enveloppes 8 lors de la mise sous vide, soit pour les isoler afin de pouvoir créer des conditions de pression différentielle, appropriées pour la génération d'un plasma dans les récipients.

Au total, les dispositions conformes à l'invention, qui consistent à établir un mode de couplage TM 120 pour être en mesure de traiter deux récipients simultanément, se révèlent bénéfiques dans le sens où l'on a certes besoin de dédoubler tous les éléments coopérant de façon directe avec les deux récipients (deux enveloppes en quartz, deux injecteurs, deux moyens de support, deux orifices de vide), mais où le reste de l'installation demeure commun (une seule cavité, un seul générateur UHF, une seule source et une seule amenée pour le vide, une seule source et une seule amenée pour le gaz précurseur, un seul capteur de pression interne, un seul capteur de pression externe, un seul couvercle et donc un seul mécanisme d'actionnement (abaissement, soulèvement) du couvercle, un seul mécanisme de préhension des récipients pour leur mise en place et leur enlèvement, etc.).

Au surplus, le couvercle 9 étant unique, on conserve des moyens d'actionnement uniques dudit couvercle pour la fermeture/ouverture de la cavité 1, tels que ceux exposés dans le document FR-A-2 799 994.

D'une façon générale, l'agencement de la cavité 1 doit respecter la symétrie apportée par les deux champs centraux $4_A$, $4_B$. En particulier, la fenêtre 2 par laquelle le guide d'ondes débouche dans la cavité 1 est disposée dans l'axe entre les deux champs centraux $4_A$, $4_B$ comme visible aux figures 1 et 2. De même des colonnes de support des plateaux $17_i$, $17_s$ de réglage d'impédance pour respectivement les champs externes $5_A$, $5_B$ (non représentées pour laisser les dessins lisibles clairement ; voir par exemple le document FR-A-2 792 854) doivent être disposées symétriquement de part et d'autre de la fenêtre 2.

**Revendications**

**1.** Procédé de dépôt d'un revêtement sur une face d'un récipient (3) en matériau thermoplastique à l'aide d'un plasma à basse pression par excitation d'un gaz précurseur par des ondes électromagnétiques UHF dans une cavité (1) sous vide de forme circulaire recevant ledit récipient,

**caractérisé en ce qu'**on choisit une fréquence des ondes électromagnétiques UHF qui est telle et on donne à la cavité (1) une dimension qui est telle que soit créé un mode de couplage propre à engendrer plusieurs champs électromagnétiques à l'intérieur de la cavité, et **en ce qu'**on dispose plusieurs récipients dans ladite cavité (1) respectivement coaxialement aux champs électromagnétiques,

ce grâce à quoi il est possible de traiter simultanément plusieurs récipients (3) dans la même cavité (1).

**2.** Procédé selon la revendication 1, **caractérisé en ce qu'**on établit un mode de couplage TM 120 qui génère deux champs centraux ($4_A$, $4_B$) à l'intérieur de la cavité,

ce grâce à quoi on peut traiter simultanément deux récipients (3) dans ladite cavité (1).

**3.** Dispositif de dépôt d'un revêtement sur une face d'au moins un récipient (3) en matériau thermoplastique à l'aide d'un plasma à basse pression par excitation d'un gaz précurseur par des ondes électromagnétiques UHF dans une cavité (1) sous vide de forme circulaire recevant ledit récipient (3), comprenant un générateur (7) d'ondes UHF et un guide d'ondes UHF pour raccorder ledit générateur à une fenêtre (2) de la paroi latérale de la cavité (1),

**caractérisé en ce que** le générateur (7) émet une onde électromagnétique ayant une fréquence f = 2,455 GHz et **en ce que** le diamètre de la cavité (1) est d'environ 273 mm pour l'établissement d'un mode de couplage TM 120 générant deux champs centraux ($4_A$, $4_B$) dans la cavité (1),

ce grâce à quoi il est possible de traiter simultanément deux récipients (3) dans ladite cavité (1).

**4.** Dispositif selon la revendication 3, **caractérisé en ce que** la cavité (1) renferme deux enveloppes (8) en quartz montées de façon étanche dans celle-ci et disposées respectivement sensiblement coaxialement aux deux champs centraux ($4_A$, $4_B$), **en ce que** la cavité (1) comporte une fenêtre (2) unique pour l'injection des ondes UHF, la fenêtre (2) étant située dans l'axe de symétrie des deux champs centraux ($4_A$, $4_B$), et **en ce qu'**un couvercle (9) unique d'obturation de la cavité (1) est équipé d'un unique raccordement (10) à une source de vide qui est dédoublé (en 11) pour être relié aux deux susdites enveloppes (8) respectivement, de deux injecteurs (13) de gaz précurseur raccordés à une source unique de gaz précurseur et de deux moyens (12) de support pour respectivement les deux récipients (3).

**5.** Dispositif selon la revendication 4, **caractérisé en ce qu'**il comporte des plateaux inférieur ($17_i$) et supérieur ($17_s$) à position réglable propres à agir sur les champs de retour ($5_A$, $5_B$) respectifs afin d'affiner le couplage en fonction de divers types de récipients (3) susceptibles d'être traités.

**6.** Dispositif selon la revendication 4 ou 5, **caractérisé en ce qu'**il est agencé pour le revêtement interne de récipients et **en ce qu'**à cette fin les injecteurs (13) de gaz précurseur sont agencés pour plonger à l'intérieur des récipients (3) respectifs lorsque ceux-ci sont supportés par des moyens de support dans les enveloppes (8).


**Claims**

**1.** A method for depositing a coating on one face of at least one container (3) made of a thermoplastic material using a low-pressure plasma by excitation of a precursor gas by UHF electromagnetic waves in a circular vacuum chamber (1) containing said container,

**characterized in that** a frequency of the UHF electromagnetic waves is selected such that and the chamber (1) is sized such that a coupling mode is generated which is adapted to generate several electromagnetic fields inside the chamber, and **in that** several containers are disposed inside said chamber (1) respectively coaxial with the electromagnetic fields,

whereby it is possible for several respective containers (3) to be simultaneously treated in the same chamber (1).

**2.** The method as claimed in claim 1, **characterized in that** a TM 120 coupling mode is established, which generates two central fields ($4_A$, $4_B$) inside the chamber, whereby two containers (3) can be simultaneously treated in said chamber (1).

**3.** A device for depositing a coating on one face of at least one container (3) made of a thermoplastic material using a low-pressure plasma by excitation of a precursor gas by UHF electromagnetic waves in a circular vacuum chamber (1) containing said container (3), which device comprises a UHF wave generator (7) and a UHF waveguide for connecting said generator to a window (2) in the side wall of the chamber (1),

**characterized in that** the generator (7) emits an electromagnetic wave having a frequency f = 2.455 GHz, and **in that** the diameter of the chamber (1) is approximately 273 mm to establish a TM 120 coupling mode that generates two central fields ($4_A$, $4_B$) inside the chamber (1),

whereby two containers (3) can be simultaneously treated in said chamber (1).

4. The device as claimed in claim 3, **characterized in that** the chamber (1) contains two quartz envelopes (8) mounted in a vacuum-tight manner therein and placed respectively substantially coaxial with the two central fields ($4_A$, $4_B$), **in that** the chamber (1) includes a single window (2) for injecting the UHF waves, the window (2) being located along the axis of symmetry of the two central fields ($4_A$, $4_B$), and **in that** a single cover (9) for closing off the chamber (1) is equipped with a single coupler (10) for connection to a vacuum source, which is divided into two (at 11) in order to be connected to said two respective envelopes (8), with two precursor gas injectors (13) that are connected to a single precursor gas source and with two support means (12) for the two respective containers (3).

5. The device as claimed in claim 4, **characterized in that** it includes positionally adjustable lower ($17_i$) and upper ($17_s$) plates adapted for acting on the respective return fields ($5_A$, $5_B$) so as to refine the coupling according to the various types of container (3) to be treated.

6. The device as claimed in claim 4 or 5, **characterized in that** it is designed for coating the inside of containers and **in that** for this purpose, the precursor gas injectors (13) are designed to plunge inside the respective containers (3) when the latter are supported by support means in the envelopes (8).

**Patentansprüche**

1. Verfahren zum Auftragen einer Beschichtung auf einer Seite wenigstens eines Behälters (3) aus thermoplastischem Material mit Hilfe eines Niederdruckplasmas durch Erregung eines Vorläufergases durch elektromagnetische UHF-Wellen in einem den Behälter aufnehmenden runden Vakuum-Hohlraum (1),
**dadurch gekennzeichnet, dass** die Frequenz der elektromagnetischen UHF-Wellen solchermaßen gewählt wird und der Hohlraum (1) eine solche Größe erhält, dass ein Kopplungsmodus zum Erzeugen mehrerer elektromagnetischer Felder innen in dem Hohlraum gebildet wird, und dass mehrere Behälter in dem Hohlraum (1) jeweils koaxial zu den elektromagnetischen Feldern angeordnet sind,
wodurch die gleichzeitige Behandlung mehrerer Behälter (3) in ein und demselben Hohlraum (1) möglich ist.

2. Verfahren nach Anspruch 1,
**dadurch gekennzeichnet, dass** ein Kopplungsmodus TM 120 gebildet wird, der innen in dem Hohlraum zwei zentrale Felder ($4_A$, $4_B$) erzeugt,
wodurch zwei Behälter (3) in dem Hohlraum (1) gleichzeitig behandelt werden können.

3. Vorrichtung zum Auftragen einer Beschichtung auf einer Seite wenigstens eines Behälters (3) aus thermoplastischem Material mit Hilfe eines Niederdruckplasmas durch Erregung eines Vorläufergases durch elektromagnetische UHF-Wellen in einem den Behälter (3) aufnehmenden runden Vakuum-Hohlraum (1), mit einem UHF-Wellen-Generator (7) und einem UHF-Wellenleiter zum Anschließen des Generators an ein Fenster (2) der Seitenwand des Hohlraums (1),
**dadurch gekennzeichnet, dass** der Generator (7) eine elektromagnetische Welle mit einer Frequenz f = 2,455 GHz aussendet, und dass der Durchmesser des Hohlraums (1) etwa 273 mm beträgt, um einen Kopplungsmodus TM 120 zu bilden, der in dem Hohlraum (1) zwei zentrale Felder ($4_A$, $4_B$) erzeugt,
wodurch die gleichzeitige Behandlung von zwei Behältern (3) in dem Hohlraum (1) möglich ist.

4. Vorrichtung nach Anspruch 3,
**dadurch gekennzeichnet, dass** der Hohlraum (1) zwei Quarz-Gehäuse (8) umschließt, die in diesem dicht montiert und jeweils im Wesentlichen koaxial zu den beiden zentralen Feldern ($4_A$, $4_B$) angeordnet sind, dass der Hohlraum (1) ein einziges Fenster (2) zum Einschießen von UHF-Wellen aufweist, wobei das Fenster (2) in der Symmetrieachse der beiden zentralen Felder ($4_A$, $4_B$) liegt, und dass ein einziger Deckel (9) zum Verschließen des Hohlraums (1) versehen ist mit einem einzigen Anschluss (10) an eine Unterdruckquelle, der zur Verbindung mit den beiden Gehäusen (8) geteilt (11) ist, mit zwei an eine einzige Vorläufergas-Quelle angeschlossene Vorläufergas-Injektoren (13) und mit zwei Mitteln (12) zum jeweiligen Halten der beiden Behälter (3).

5. Vorrichtung nach Anspruch 4,

**dadurch gekennzeichnet, dass** sie eine untere ($17_i$) und eine obere ($17_s$) Platte mit verstellbarer Position zum Einwirken auf die jeweiligen Rückführungsfelder ($5_A$, $5_B$) umfasst, um die Kopplung in Abhängigkeit von den verschiedenen Typen der zu behandelnden Behälter (3) zu verfeinern.

6. Vorrichtung nach Anspruch 4 oder 5,
   **dadurch gekennzeichnet, dass** sie für die innere Beschichtung der Behälter ausgebildet ist, und dass zu diesem Zweck die Vorläufergas-Injektoren (13) zum Eintauchen innen in die jeweiligen Behälter (3) ausgebildet sind, wenn diese von den Haltemitteln in den Gehäusen (8) gehalten werden.

UHF

FIG.1.

FIG.2.

**EP 1 566 081 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2799994
- FR 2799994 A
- FR 2792854 A